Europäisches Patentamt

European Patent Office

Office européen des brevets

(11) Veröffentlichungsnummer: **0 210 395 B1**

# EUROPÄISCHE PATENTSCHRIFT

(45) Veröffentlichungstag der Patentschrift: **19.08.92**

(51) Int. Cl.⁵: **H03M 5/14**, H04L 25/49

(21) Anmeldenummer: **86108027.3**

(22) Anmeldetag: **12.06.86**

Die Akte enthält technische Angaben, die nach
dem Eingang der Anmeldung eingereicht wurden
und die nicht in dieser Patentschrift enthalten sind.

(54) **Umcodierverfahren.**

(30) Priorität: **30.07.85 DE 3527181**

(43) Veröffentlichungstag der Anmeldung:
**04.02.87 Patentblatt 87/06**

(45) Bekanntmachung des Hinweises auf die
Patenterteilung:
**19.08.92 Patentblatt 92/34**

(84) Benannte Vertragsstaaten:
**FR GB IT**

(56) Entgegenhaltungen:
**EP-A- 0 013 990**
**FR-A- 2 535 556**

(73) Patentinhaber: **ANT Nachrichtentechnik GmbH**
**Gerberstrasse 33**
**W-7150 Backnang(DE)**

(72) Erfinder: **Mönch, Detlef, Dipl.-Ing.**
**Von-Erckertstrasse 37**
**W-8000 München 82(DE)**

## Beschreibung

Die Erfindung betrifft eine Verfahren zur Umwandlung eines Datensignals im HDB3-Code in ein Datensignal im MCMI-Code bzw. eine Schaltungsanordnung zur Durchführung dieses Verfahrens gemäß Oberbegriff des Anspruches 1 bzw. 2.

Die Leitungsfernübertragung benutzt üblicherweise einen 3-wertigen Code, beispielsweise einen HDB3-Code, welcher keine Gleichstromkomponente aufweist. Hierbei wird eine binäre 1 entweder als positiver oder als negativer Impuls dargestellt, während die Mittellage einer binären Null entspricht. In Glasfasernetzen erfolgt die Übertragung mit Hilfe eines binären 2-wertigen Code (s. beispielsweise telcom report 6 (1983) Beiheft "Nachrichtenübertragung mit Licht", Seiten 127 ff.), da hier bei der optischen Übertragung Intensitätsmodulation verwendet wird. Neuerdings werden hierfür CMI-Codes oder MCMI-Codes benutzt, wobei im ersten Fall die binäre Null durch einen negativen Zustand während der ersten Hälfte und durch einen positiven Zustand während der zweiten Hälfte eines Bitintervalls dargestellt wird. Die binäre 1 wird abwechslungsweise durch einen positiven oder negativen Impuls mit der ganzen Bitintervalllänge dargestellt.

In ähnlicher Art ist der modifizierte CMI-Code (HCMI-Code) aufgebaut, er läßt sich durch ein einfaches Bildungsgesetz aus dem HDB3-Code gewinnen, welcher vorwiegend in Europa verbreitet ist. Das Bildungsgesetz lautet (s. Technische Mitteilungen PTT 7/1979, Seiten 253-266):

| HDB3 | MCMI |
|------|------|
| 1 | 11 |
| -1 | 00 |
| 0 | 01 |

Aufgrund dieser direkten Abbildung des HDB3-Codes wird der Code auch unter dem Namen 2-Pegel-HDB3 geführt.

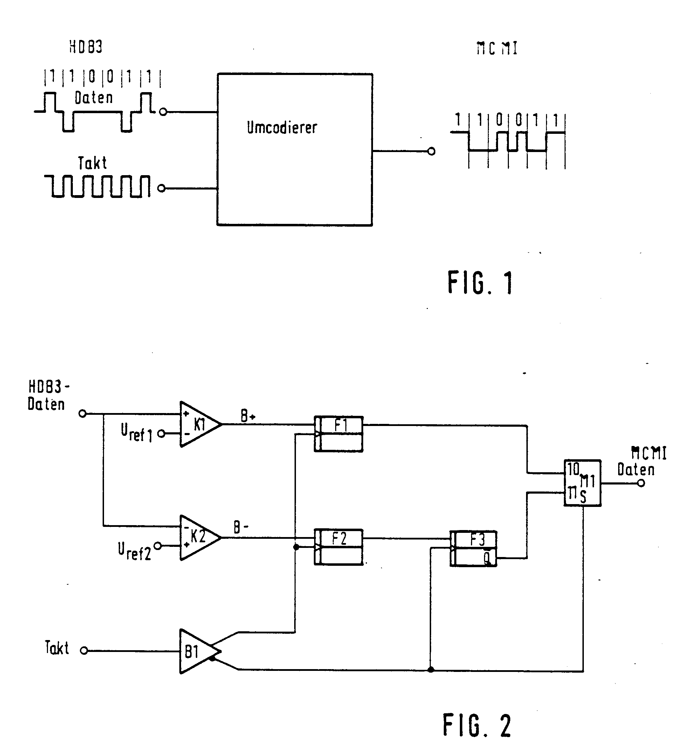

In Figur 1 ist ein Umcodierer als schwarzer Kasten dargestellt, an dessen Eingängen das HDB3-Datensignal und das zugehörige Taktsignal anliegen und an dessen Ausgang das umgewandelte MCMI-Datensignal ansteht. Die Signale sind für ein 110011-Bitmuster über der Zeit aufgetragen.

Der vorliegenden Erfindung lag die Aufgabe zugrunde, ein Umcodierverfahren und einen Umcodierer der eingangs genannten Art anzugeben, welche nur sehr wenige und einfach durchzuführende Verfahrensschritte bsw. nur wenige Bauelemente beanspruchen.

Die Lösung erfolgt mit den gekennzeichneten Merkmalen des Anspruchs 1 bzw. 2.

Die Vorteile des erfindungsgemäßen Verfahrens bzw. der Schaltungsanordnung sind die, daß unter Einhaltung der gegebenen Masken aus einem HDB3-Signal ein MCMI-Signal erzeugt werden kann, ohne einen Abgleich vornehmen zu müssen, wenn die Bitübertragungsrate variiert. Die Schaltungsanordnung hat weiterhin den Vorteil der Integrationsfähigkeit.

Durch die europäische Offenlegungsschrift EP-A-0 013 990 ist ein Verfahren gemäß Oberbegriff Anspruch 1 und ein MCMI-Codierer bekannt, wobei dieser Codierer zwei Flip-Flops, einen

Es folgt nun die Beschreibung der Erfindung anhand der Figuren.

In Figur 2 ist eine Schaltungsanordnung für den Umcodierer nach Figur 1 als Ausführungsbeispiel gezeichnet.

Die Figur 3 enthält mehrere über der Zeit aufgetragene Verläufe von Signalen gemäß Figur 2 bzw. einer modifizierten Schaltungsanordnung nach Figur 2.

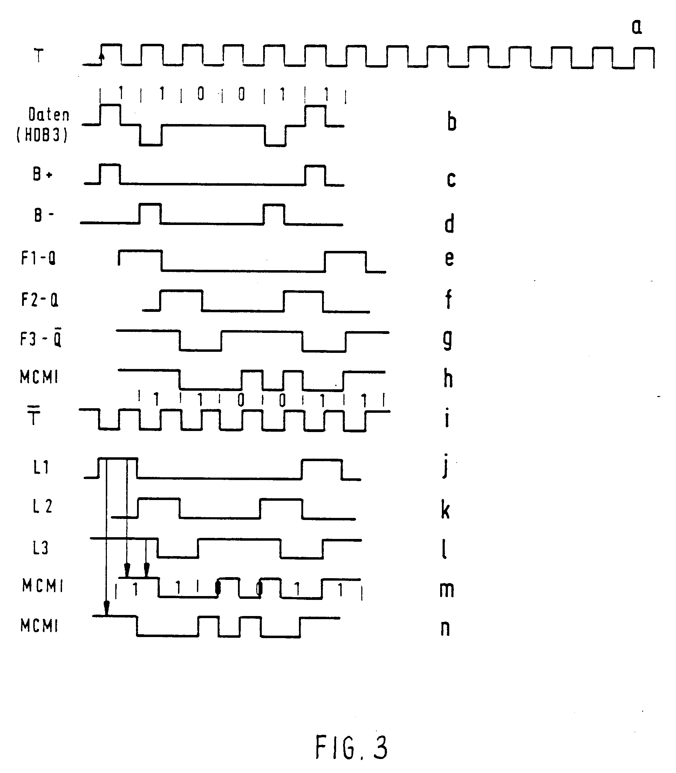

Die Figur 2 enthält zwei Komparatoren K1 und K2, deren positiver bzw. negativer Eingang mit dem HDB3-Datensignal beaufschlagt sind und die gegen eine erste bzw. zweite Referenzspannung Uref1, Uref2 arbeiten. Durch diese beiden Komparatoren wird das 3-wertige HDB3-Signal (s. Fig. 3b) in zwei 2-wertige Datenströme B+ (Fig. 3c) und B- (Fig. 3d) umgewandelt. Der erste Datenstrom enthält lediglich die positiven Impulse des HDB3-Datensignals, und der andere Datenstrom B- enthält lediglich die negativen Impulse des HDB3-Datensignals in invertierter Form. Den Komparatorausgängen sind zwei D-Flip-Flops F1 und F2 nachgeschaltet, die mit dem Takt T getaktet sind. Durch die beiden Flip-Flops werden die beiden Datenströme B+ und B- abgetastet, ihre Ausgangssignale sind der Figur 3e und 3f zu entnehmen.

Dem Ausgang F2-Q des zweiten D-Flip-Flops ist ein weiteres D-Flip-Flop F3 nachgeschaltet, welches mit dem invertierten Takt $\overline{T}$ getaktet ist und damit das Signal um eine halbe Taktperiode verzögert (s. Fig. 3g). Dieses Ausgangssignal wird nun in invertierter Form, F3-$\overline{Q}$, zusammen mit dem Ausgangssignal des ersten Flip-Flops F1-Q auf einen Multiplexer M1 gegeben, welcher mit dem invertierten Takt $\overline{T}$ getaktet wird und durch welchen die beiden Signale Halbbittakt-periodenweise ineinander verschachtelt werden. Das Ausgangssignal des Multiplexers ist das gewünschte MCMI-Datensignal (Fig. 3h).

Die Speicherfunktionen der Flip-Flops gemäß Figur 2 können auch durch Latches realisiert werden, welche noch weniger aufwendig sind. Am grundsätzlichen Verlauf der Signale ändert sich praktisch nichts. Die Signalverläufe sind in den Figuren 3j bis 3n dargestellt, wobei von Latches L1, L2 und L3 ausgegangen wird, die während der Hochpegelphase des Taktes T das Eingangssignal transparent an den Ausgang schalten und diesen Zustand während der Niedrigpegelphase speichern. Voraussetzung ist wie auch bei den D-Flip-Flops eine Haltezeit von Null. Der Multiplexer kann auch vom nicht invertierten Takt T geschaltet werden (s. Fig. 3n, in diesem Fall steht das ausgangsseitige MCMI-Datensignal eine halbe Taktperiode früher zur Verfügung). Gleichbedeutend damit ist auch eine Vertauschung der zu multiplexenden Bitströme an den Multiplexer-Eingängen A0 und A1.

Das Tastverhältnis des Datenausgangssignals des Multiplexers ist direkt abhängig vom Tastverhältnis des Eingangstaktes. Um das ideale Verhältnis von 1:1 zu erreichen, wird vorteilhafterweise aus dem invertierten und dem nicht invertierten MCMI-Ausgangssignal ein Differenzsignal gebildet, welches integriert wird und auf das Takt- bzw. auf ein davon abgeleitetes Signal und gegenphasig auf das invertierte Takt- bzw. auf ein davon abgeleitetes Signal addiert wird, und es werden die so gebildeten Summensignale den beiden Eingängen eine Differenzverstärkers hoher Verstärkung zugeführt, an dessen invertierendem und nicht invertierendem Ausgang die zueinander gegenphasigen Taktsignale zur Taktung des Umcodierers abgegriffen werden. Zur Bildung des Differenzsignals wird ebenfalls ein Differenzverstärker hoher Verstärkung mit normalem und invertierendem Ausgang verwendet. Die Integration erfolgt vorteilhafterweise mittels eines symmetrischen RC-Gliedes als symmetrischem Tiefpaß, und das invertierte bzw. nicht invertierte Taktsignal wird über Entkopplungswiderstände auf das Tiefpaß-Ausgangssignal addiert. Mit Hilfe einer solchen Regelschaltung erhält man einen auf feste Symmetrie getrimmten, geregelten Takt.

**Patentansprüche**

1. Verfahren zur Umwandlung eines Datensignals im HDB3-Code in ein Datensignal im MCMI-Code, wobei das HDB3-Datensignal aufgetrennt wird in zwei binäre Signale, wobei das eine nur die positiven Impulse (B+) und das andere nur die negativen Impulse invertiert (B-) enthält, und das eine binäre Signal in einem ersten Speicher und das andere in einem zweiten Speicher synchron mit dem Datentakt (T) zwischengespeichert werden, dadurch gekennzeichnet, daß das Ausgangssignal des zweiten Speichers um eine halbe Taktperiode (T/2) verzögert und invertiert wird und daß jeweils dieses so gewonnene Signal während der ersten halben Taktperiode und das Ausgangssignal des ersten Speichers während der zweiten halben Taktperiode das MCMI-Datensignal ergibt.

2. Schaltungsanordnung zur Durchführung des Verfahrens nach Anspruch 1, bei der die Auftrennung durch 2 Komparatoren (K1, K2) erfolgt, wobei das HDB3-Datensignal dem positiven Eingang des ersten, gegen eine erste Referenzspannung (Uref1) arbeitenden Komparators (K1) und dem negativen Eingang des zweiten, gegen eine zweite Referenzspannung (Uref2) arbeitenden Komparators (K2) zugeführt wird, dadurch gekennzeichnet, daß
daß zur Verzögerung ein dritter Speicher vorgesehen ist und daß ein durch den Datentakt (T) gesteuerter (S) Multiplexer (M) vorgesehen ist, dessen 2 Eingänge (A0, A1) das Ausgangssignal des ersten Speichers und das verzögerte und invertierte Ausgangssignal des zweiten Speichers zugeführt und alternierend jeweils während einer halben Taktperiode an den Ausgang des Multiplexers durchgeschaltet werden.

3. Schaltungsanordnung nach Anspruch 2, dadurch gekennzeichnet, daß die Speicher D-Flip-Flop-Speicher (F1, F2, F3) sind.

4. Schaltungsanordnung nach Anspruch 2, dadurch gekennzeichnet, daß die Speicher Latches (L1, L2, L3) sind, die alternierend während der einen Halb periode des Taktes das Eingangssignal transparent an ihren Ausgang schalten und diesen Zustand während der anderen Halbperiode des Taktes speichern.

**Claims**

1. Method for the conversion of a data signal in the HDB3 code into a data signal in the MCMI code, wherein the HDB3 data signal is split up into two binary signals, wherein the one contains only the positive pulses (B+) and the other contains only the negative pulses (B-) and wherein the one binary signal is intermediately stored in a first and the other is intermediately stored in a second storage device synchronously with the data clock pulse (T), characterised thereby, that the output signal of the

3

second storage device is delayed by half a clock pulse period (T/2) and inverted and that this signal so obtained during each first half clock pulse period and the output signal of the first storage device during each second half clock pulse period yields the MCMI data signal.

2. Circuit arrangement for the performance of the method according to claim 1, in which the splitting-up takes place by two comparators (K1, K2), wherein the HDB3 data signal is fed to the positive input of the first comparator (K1), which operates against a first reference voltage (Uref1), and to the negative input of the second comparator (K2), which operates against a second reference voltage (Uref2), characterised thereby, that a third storage device is provided for the delay and that a multiplexer (M) is provided, which is controlled by the data clock pulse (T) and to the two inputs (A0, A1) of which the output signal of the first storage device and the delayed and inverted output signal of the second storage device are fed and switched through to the output of the multiplexer in alternation each during a respective half clock pulse period.

3. Circuit arrangement according to claim 2, characterised thereby, that the storage devices are D-flip-flip storage devices (F1, F2, F3).

4. Circuit arrangement according to claim 2, characterised thereby, that the storage devices are latches (L1, L2, L3), which in alternation switch the input signal transparently to their output during the one half clock pulse period and store this state during the other half clock pulse period.

**Revendications**

1. Procédé de conversion du code HDB3 d'un premier signal de données en code MCMI d'un second signal de données, le signal de données HDB3 étant séparé en deux signaux binaires, le premier ne contenant que les impulsions positives (B+) et le second que les impulsions négatives, sous forme inversée (B-), le premier signal binaire étant stocké temporairement dans une première mémoire et le second dans une seconde mémoire, de manière synchrone au rythme des données (T), caractérisé en ce que le signal de sortie de la seconde mémoire est temporisé d'une demi-période (T/2) du signal d'horloge et est inversé et en ce que le signal de données MCMI est produit par le signal ainsi produit pendant la première demi-période du signal d'horloge et par le signal de sortie de la première mémoire pendant la seconde demi-période du signal d'horloge.

2. Montage de circuits pour la mise en oeuvre du procédé selon la revendication 1, où la séparation est assurée par deux comparateurs (K1, K2), le signal de données HDB3 formant l'entrée positive du premier comparateur (K1) fonctionnant par rapport à une première tension de référence (Uréf1) et l'entrée négative du second comparateur (K2) fonctionnant par rapport à une seconde tension de référence (Uréf2), caractérisé en ce que l'on utilise pour temporiser une troisième mémoire et en ce qu'un multiplexeur (M) commandé (S) par le rythme des données (T) reçoit sur ses deux entrées (A0, A1) le signal de sortie de la première mémoire et le signal de sortie temporisé et inversé de la seconde mémoire, et les fournit à sa sortie, alternativement, pendant une demi-période du signal d'horloge.

3. Montage de circuits selon la revendication 2, caractérisé en ce que les mémoires sont des bascules D (F1, F2, F3).

4. Montage de circuits selon la revendication 2, caractérisé en ce que les mémoires sont des échantillonneurs (L1, L2, L3) qui, alternativement, laissent passer le signal d'entrée à la sortie de manière transparente pendant la première demi-période du signal d'horloge et conservent cet étant pendant la seconde demi-période.

4

HDB3

|1|1|0|0|1|1|

Daten

Takt

Umcodierer

MCMI

1|1|0|0|1|1

## FIG. 1

HDB3-
Daten

$U_{ref1}$

K1

B+

F1

$U_{ref2}$

K2

B-

F2

F3

MCMI
Daten

Takt

B1

## FIG. 2

FIG. 3